# EUROPEAN PATENT SPECIFICATION

(11) **EP 3 907 074 B1**
(45) Date of publication and mention of the grant of the patent: **08.04.2026**
(21) Application number: 19905490.9
(22) Date of filing: 25.12.2019
(51) Int. Cl.: B32B 27/00, C09J 11/04, C09J 183/04, C09J 183/05, C09J 183/07, C09J 201/00, H01L 21/02, H01L 21/304, C09J 7/30, C09J 7/40, B32B 7/12, C08K 3/04

(54) **ADHESIVE COMPOSITION FOR OPTICAL IRRADIATION PEELING, LAMINATE BODY, AND LAMINATE BODY PRODUCTION METHOD AND PEELING METHOD**
HAFTZUSAMMENSETZUNG ZUR ABLÖSUNG DURCH OPTISCHE BESTRAHLUNG, LAMINATKÖRPER, HERSTELLUNGSVERFAHREN UND ABZIEHVERFAHREN
COMPOSITION ADHÉSIVE POUR LE PELAGE PAR IRRADIATION OPTIQUE, CORPS STRATIFIÉ, ET PROCÉDÉ DE PRODUCTION DE CORPS STRATIFIÉ ET PROCÉDÉ DE PELAGE

(30) Priority: 27.12.2018 JP 2018245938; 27.05.2019 JP 2019098890
(43) Date of publication of application: 10.11.2021
(73) Proprietor: Nissan Chemical Corporation, Tokyo 103-6119 (JP)
(72) Inventor: OGINO, Hiroshi, Toyama-shi, Toyama 939-2792 (JP); SHINJO, Tetsuya, Toyama-shi, Toyama 939-2792 (JP); KARASAWA, Ryo, Toyama-shi, Toyama 939-2792 (JP); OKUNO, Takahisa, Toyama-shi, Toyama 939-2792 (JP)
(74) Representative: Hoffmann Eitle
(86) International application number: PCT/JP2019/051020
(87) International publication number: WO 2020/138240

(56) References cited:
- WO-A1-2017/221772
- WO-A1-2017/221772
- JP-A- 2016 138 182
- JP-A- 2016 138 182
- JP-A- 2017 014 309
- JP-A- 2017 045 829
- JP-A- 2017 066 194

## Description

### Technical Field

The present invention relates to an adhesive composition for use in debonding with light irradiation, to a laminate, to a method for producing the laminate (hereinafter may be referred to as a "laminate production method"), and to a laminate debonding method.

### Background Art

Conventionally, electronic elements and wires are 2-dimensionally (within a plane) integrated on a semiconductor wafer. In a trend toward further integration, demand has arisen for a semiconductor integration technique which achieves 3-dimensional integration (i.e., stacking) in addition to 2-dimensional integration. In the technique of 3-dimensional integration, a number of layers are stacked by the mediation of through silicon vias (TSVs). In integration of multiple layers, each component wafer to be stacked is thinned by polishing (i.e., grinding) a surface opposite the circuit-furnished surface (i.e., a back surface), and the thus-thinned semiconductor wafers are stacked.

Before thinning, the semiconductor wafer (may also be called simply "wafer") is fixed to a support for facilitating polishing by means of a polishing machine (i.e., grinder). Since the fixation must be readily removed after polishing, the fixation is called temporary bonding. Temporary bonding must be easily removed from the support. When such temporary bonding is removed by excessive force, in some cases a thinned semiconductor wafer may be broken or deformed. In order to prevent such a phenomenon, the temporarily bonded support is detached in a gentle manner. However, from another aspect, it is not preferred that the temporarily bonded support be removed or slid by a stress applied during polishing of the back surface of the semiconductor wafer. Therefore, temporary bonding must withstand the stress during polishing and must be easily removed after polishing.

For example, one required performance includes having high stress (i.e., strong adhesion) within the plane during polishing and low stress (i.e., weak adhesion) toward the thickness direction during detaching.

There have been reported several methods for such bonding and debonding, the methods employing irradiation with laser light (see Patent Documents 1 and 2).

However, the adhesive for temporary bonding which is used in the bonding/debonding process generates heat and gas when irradiated with laser light, and wafers suffer considerable damage.

WO 2017/221772 A1 describes an adhesive for separably bonding a support to the circuit-bearing surface of a wafer and thereby enabling the back surface of the wafer to be processed and which cures upon heating from the support side or the wafer side to thereby make it possible to select a plane where the adhesive layer is peeled off, the adhesive comprising a component (A), which cures through hydrosilylation, and a component (B), which comprises a polydimethylsiloxane and which may be a polydimethylsiloxane having a viscosity of 1,100-2,000,000 mm²/s. Also described is a method for laminate formation, the method comprising bonding a surface of a second substrate to an adhesive layer obtained by applying the adhesive to a surface of a first substrate and heating the assemblage from the first substrate side; and a separation method comprising bonding a surface of a second substrate to an adhesive layer obtained by applying the adhesive to a surface of a first substrate, heating the assemblage from the first substrate side to cure the adhesive and form a laminate, subsequently processing the laminate, and causing a separation between the first substrate and the adhesive layer.

JP 2016 138182 A describes an adhesive composition for temporary fixing that contains one or more kind of (meth)acrylate selected from polyfunctional (meth)acrylate containing three or more (meth)acryloyl groups in a molecule and alicyclic (meth)acrylate, a photoinitiator exhibiting specific mass reduction rate and carbon black having specific area of 30 to 100 m/g at specific percentage.

### Prior Art Documents

### Patent Documents

Patent Document 1: Japanese Patent Application Laid-Open (kokai) No. 2004-64040
Patent Document 2: Japanese Patent Application Laid-Open (kokai) No. 2012-106486

### Summary of the Invention

### Problems to be Solved by the Invention

The present invention has been conceived under such circumstances. Thus, an object of the present invention is to provide an adhesive composition for use in debonding with light irradiation which composition provides a thin film suitably serving as an adhesive layer which has excellent heat resistance during joining to a support (i.e., curing), processing of the back surface of a wafer, and a part-mounting process and which can be easily debonded through irradiation with laser light during removal of the support. Another object is to provide a laminate employing the adhesive composition, and a production method and debonding method for the laminate.

### Means for Solving the Problems

The present inventors have carried out extensive studies to attain the aforementioned objects, and have found that, by adding carbon black to an adhesive component containing a component (A) which is cured through hydrosilylation and which *per* se does not absorb laser light to such an extent as to readily achieve debonding, the bonding strength provided by the adhesive component decreases by the action of the laser light absorbed by carbon black, to thereby achieve easy debonding. The present invention has been accomplished on the basis of this finding.

Accordingly, in a first aspect of the present invention, there is provided an adhesive composition for use in debonding with light irradiation, which composition can achieve debonding through irradiation with light, characterized in that the adhesive composition comprises an adhesive component and carbon black, and the adhesive component contains a component (A) which is cured through hydrosilylation.

A second aspect of the present invention is drawn to a specific embodiment of the adhesive composition according to the first aspect for use in debonding with light irradiation, wherein the adhesive composition further comprises a component (B) containing at least one species selected from the group consisting of a component containing an epoxy-modified polyorganosiloxane, a component containing a methyl-group-containing polyorganosiloxane, and a component containing a phenyl-group-containing polyorganosiloxane.

A third aspect of the present invention is drawn to a specific embodiment of the adhesive composition according to the first or second aspect for use in debonding with light irradiation, wherein the component (A) which is cured through hydrosilylation comprises a polysiloxane (A1) having one or more units selected from the group consisting of a siloxane unit represented by SiO₂ (unit Q), a siloxane unit represented by R¹R²R³ SiO_{1/2} (unit M), a siloxane unit represented by R⁴R⁵SiO_{2/2} (unit D), and a siloxane unit represented by R⁶SiO_{3/2} (unit T) (wherein each of R¹ to R⁶ is a group or an atom bonded to a silicon atom and represents an alkyl group, an alkenyl group, or a hydrogen atom) and a platinum group metal catalyst (A2); and the polysiloxane (A1) comprises a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T' (wherein each of R^{1'} to R^{6'} is a group bonded to a silicon atom and represents an alkyl group or an alkenyl group, and at least one of R^{1'} to R^{6'} is an alkenyl group), and a polyorganosiloxane (a2) having one or more units selected from the group consisting of a siloxane unit represented by SiO₂ (unit Q''), a siloxane unit represented by R^{1"}R^{2"}R^{3"}SiO_{1/2} (unit M"), a siloxane unit represented by R^{4"}R^{5"}SiO_{2/2} (unit D"), and a siloxane unit represented by R^{6"}SiO_{3/2} (unit T''), and at least one unit selected from the group consisting of unit M'', unit D'', and unit T'' (wherein each of R^{1"} to R^{6"} is a group or an atom bonded to a silicon atom and represents an alkyl group or a hydrogen atom, and at least one of R^{1"} to R^{6"} is a hydrogen atom).

A fourth aspect of the present invention is drawn to a specific embodiment of the adhesive composition according to any of the first to third aspects for use in debonding with light irradiation, wherein the amount of carbon black is 0.1 to 50 mass% with respect to that of the adhesive component.

A fifth aspect of the present invention is drawn to a specific embodiment of the adhesive composition according to any of the first to fourth aspects for use in debonding with light irradiation, wherein the adhesive composition contains a solvent.

A sixth aspect of the present invention is drawn to a specific embodiment of the adhesive composition according to the fifth aspect for use in debonding with light irradiation, wherein the amount of the solvent is 10 to 90 mass% with respect to the entire amount of the adhesive composition.

A seventh aspect of the present invention is drawn to a specific embodiment of the adhesive composition according to any of the first to sixth aspects for use in debonding with light irradiation, wherein the adhesive composition contains a component containing at least one species selected from the group consisting of a component containing an epoxy-modified polyorganosiloxane, a component containing a methyl-group-containing polyorganosiloxane, and a component containing phenyl-group-containing polyorganosiloxane.

In an eighth aspect of the present invention, there is provided a laminate comprising a first substrate formed of a semiconductor-forming substrate, a second substrate formed of a support substrate which allows passage of laser light, and an adhesive layer, wherein the adhesive layer is a cured film formed from an adhesive composition for use in debonding with light irradiation as recited in any of the first to seventh aspects.

In a ninth aspect of the present invention, there is provided a method for producing a laminate, the method comprising a first step of applying an adhesive composition for use in debonding with light irradiation as recited in any of the first to seventh aspects onto a surface of a first or second substrate, to thereby form an adhesive coating layer; and a second step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment.

In a tenth aspect of the present invention, there is provided a debonding method comprising irradiating a laminate produced through a laminate production method as recited in the ninth aspect with laser light from the second substrate side of the laminate, to thereby debond the second substrate.

An eleventh aspect is drawn to a specific embodiment of the debonding method according to the tenth aspect, wherein the laser light has a wavelength of 190 nm to 600 nm.

### Effects of the Invention

The adhesive composition of the present invention for use in debonding with light irradiation exhibits excellent dispersibility in organic solvent and high light-absorbability. In addition, the adhesive composition of the present invention contains a specific adhesive component and carbon black, which is less expensive than other inorganic carbon materials. Therefore, the adhesive composition of the present invention can provide a thin film suitably serving as an adhesive layer for use in debonding with light irradiation; i.e., a thin film which suitably bonds a support to a workpiece (e.g., a wafer) during processing of the workpiece and which, after processing, achieves debonding by a decrease in bonding strength through appropriate absorption of laser light. Therefore, employment of the adhesive composition of the present invention for use in debonding with light irradiation can produce, at lower cost, an adhesive layer that achieves debonding through irradiation with laser light without application of an excessive load for debonding to a support or a workpiece (e.g., a wafer).

The laminate of the present invention includes a first substrate formed of a semiconductor-forming substrate, a second substrate formed of a support substrate that allows passage of laser light, and an adhesive layer formed of a cured film formed from the adhesive composition for use in debonding with light irradiation having the aforementioned characteristic features. Thus, the adhesive layer and the first substrate can be readily debonded from the second substrate by irradiating the adhesive layer with laser light from the second substrate side.

### Brief Description of the Drawings

[FIG. 1] A schematic view for illustrating the laminate production method of the present invention.
[FIG. 2] A schematic view for illustrating an example of the debonding method of the present invention.

### Modes for Carrying Out the Invention

The present invention will next be described in more detail.

The adhesive composition of the present invention for use in debonding with light irradiation can be employed for, for example, forming an adhesive layer which can bond a support and a circuit-side of a wafer in a peelable manner when present therebetween and which is used for processing the backside of the wafer. The adhesive composition contains an adhesive component and carbon black, and the adhesive component contains a component (A) which is cured through hydrosilylation.

The adhesive composition of the present invention for use in debonding with light irradiation forms an adhesive layer that can achieve debonding through irradiation with laser light. Since the adhesive layer contains carbon black, the bonding strength of the adhesive layer is reduced through suitable absorption of laser light. Thus, the adhesive layer can be debonded off without application of an excessive load for debonding to, for example, a support or a wafer, which is advantageous.

By the mediation of the adhesive layer formed from the adhesive composition of the present invention for use in debonding with light irradiation, a support and a wafer are temporarily bonded. The wafer can be thinned by, for example, processing (e.g., polishing) a surface opposite the circuit surface of the wafer (i.e., a back surface).

The laminate of the present invention includes a first substrate formed of a semiconductor-forming substrate, a second substrate formed of a support substrate that allows passage of laser light, and an adhesive layer formed of a cured film formed from the aforementioned adhesive composition for use in debonding with light irradiation. Any functional layer that allows or does not allow passage of laser light may be provided between any of the substrates and the adhesive layer. In this case, the functional layer is appropriately selected so as not to inhibit debonding with laser light irradiation.

In one preferred embodiment of the present invention, the laminate of the present invention includes a first substrate formed of a semiconductor-forming substrate, a second substrate formed of a support substrate that allows passage of laser light, and an adhesive layer which is formed of a cured film formed from the aforementioned adhesive composition for use in debonding with light irradiation and which is provided between these two substrates so as to be in contact with them.

The laminate of the present invention can achieve debonding by irradiating the laminate with laser light from the second substrate side (which substrate allows passage of laser light) without application of an excessive load for debonding. In other words, the laser light which has passed through the second substrate is absorbed by the adhesive layer containing carbon black. Although the laser light would otherwise pass through the adhesive layer, the bonding strength provided by the adhesive layer decreases by the action of the absorbed laser light. Thus, the second substrate can be removed without application of an excessive load for debonding. Also, since the adhesive layer of the present invention contains, as an adhesive component, a component (A) which is cured through hydrosilylation, there occurs neither considerable generation of gas nor large heat generation, which would otherwise cause adverse effects during a decrease in bonding strength. Thus, the first substrate is not substantially affected, which is advantageous.

The wavelength of such laser light is generally 190 nm to 600 nm. The wavelength is preferably 250 nm or more, more preferably 300 nm or more, and preferably 580 nm or less, more preferably 560 nm or less, from the viewpoint of, for example, effective debonding at high reproducibility. The laminate of the present invention can be suitably debonded by use of laser light having a wavelength of, for example, 308 nm, 355 nm, or 532 nm.

In the present invention, the second substrate must allow passage of laser light used for debonding. However, if light irradiation can be performed from the first substrate side, the second substrate does not necessarily allow passage of laser light.

As used herein, the expression "can be debonded" or "peelable" refers to a state of lower bonding strength. In other words, it means excellent peelability for ensuring easy debonding. The bonding strength of an adhesive layer formed from the adhesive composition of the present invention for use in debonding with light irradiation is considerably reduced through irradiation with laser light, as compared with that in the stage before irradiation.

Thus, the adhesive layer formed from the adhesive composition of the present invention for use in debonding with light irradiation achieves effective bonding between, for example, a first substrate formed of a wafer and a second substrate formed of a support substrate that allows passage of laser light during processing (e.g., thinning) of the wafer. After completion of the processing, the adhesive layer is readily debonded off or removed through laser light irradiation.

Carbon black contained in the adhesive composition of the present invention for use in debonding with light irradiation is an electrically conductive carbon black such as acetylene black, KETJENBLACK, or furnace black. The carbon black may be synthesized through a known method or may be available as a commercial product. Specific examples include, but are not limited to, DENKA BLACK (registered trademark) and DENKA BLACK Li (products of Denka Co., Ltd.); KETJENBLACK EC300J, Carbon ECP, KETJENBLACK EC600JD, and Carbon ECP600JD (products of Lion Specialty Chemicals Co., Ltd.); PROPEL(registered trademark) X14, X20, X22, X25, X35, X39, D11, E3, E6, and E7, REGAL(registered trademark) 300, and VULCAN(registered trademark) 10, VULCAN 10H, 10HD, 1345, 1380, 1436, 3, 3H, 6, 6-LP, 7H, 8, 9, 9H, J, and M (products of Cabot); ASAHI AX-015 and ASAHI F-200GS (products of Asahi Carbon Co., Ltd.); high color (HCF) #2650, #2600, #2350, and #2300, medium color (MCF) #1000, #980, #970, #960, #950, #900, #850, MCF88, MA600, #750B, and #650B, general color (RCF) #52, #47, #45, #45L, #44, #40, #33, #32, #30, #25, #20, #10, #5, #95, #85, and #240, high-flowability (LFF) MA77, MA7, MA8, MA11, MA100, MA100R, MA100S, MA230, MA220, and MA14, special color (SCF) #4000B, general conductivity #3030B, #3050B, and #3230B (products of Mitsubishi Chemical Corporation); and conductive additive KS4, KS6, KS10, KS15, SFG6, SFG10, and SFG15 (products of Pacem Energy Ltd. (Shanghai Exchange Market)).

Alternatively, surface-modified (to prevent aggregation or to enhance dispersibility) carbon black or oxidized carbon black may also be used.

Still alternatively, carbon black powder may be mixed with and dispersed in an adhesive component. Also, carbon black powder may be dispersed in advance in an adhesive component or another resin component, to thereby form a master batch, or a dispersion of carbon black powder in solvent may be mixed with an adhesive component for dispersion.

The carbon black content is generally 0.1 to 50 mass% with respect to the amount of adhesive component.

The adhesive composition of the present invention for use in debonding with light irradiation contains, as an adhesive component, a component (A) which is cured through hydrosilylation.

In one more preferred embodiment of the present invention, the component (A) which is cured through hydrosilylation contains a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2); wherein the polysiloxane (A1) contains a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T', and
a polyorganosiloxane (a2) having one or more units selected from the group consisting of a siloxane unit represented by SiO₂ (unit Q"), a siloxane unit represented by R^{1"}R^{2"}R^{3"}SiO_{1/2} (unit M"), a siloxane unit represented by R^{4"}R^{5"}SiO_{2/2} (unit D"), and a siloxane unit represented by R^{6"}SiO_{3/2} (unit T''), and at least one unit selected from the group consisting of unit M'', unit D'', and unit T''.

Each of R¹ to R⁶ is a group or an atom bonded to a silicon atom and represents an alkyl group, an alkenyl group, or a hydrogen atom.

Each of R^{1'} to R^{6'} is a group bonded to a silicon atom and represents an alkyl group or an alkenyl group, and at least one of R^{1'} to R^{6'} is an alkenyl group.

Each of R^{1"} to R^{6"} is a group or an atom bonded to a silicon atom and represents an alkyl group or a hydrogen atom, and at least one of R^{1"} to R^{6"} is a hydrogen atom.

The alkyl group may be linear-chain, branched-chain, or cyclic. However, a linear-chain alkyl group and a branched-chain alkyl group are preferred. No particular limitation is imposed on the number of carbon atoms thereof, and the number of carbon atoms is generally 1 to 40, preferably 30 or less, more preferably 20 or less, still more preferably 10 or less.

Specific examples of the linear-chain or branched-chain alkyl group include, but are not limited to, methyl, ethyl, n-propyl, i-propyl, n-butyl, i-butyl, s-butyl, t-butyl, n-pentyl, 1-methyl-n-butyl, 2-methyl-n-butyl, 3-methyl-n-butyl, 1,1-dimethyl-n-propyl, 1,2-dimethyl-n-propyl, 2,2-dimethyl-n-propyl, 1-ethyl-n-propyl, n-hexyl, 1-methyl-n-pentyl, 2-methyl-n-pentyl, 3-methyl-n-pentyl, 4-methyl-n-pentyl, 1,1-dimethyl-n-butyl, 1,2-dimethyl-n-butyl, 1,3-dimethyl-n-butyl, 2,2-dimethyl-n-butyl, 2,3-dimethyl-n-butyl, 3,3-dimethyl-n-butyl, 1-ethyl-n-butyl, 2-ethyl-n-butyl, 1,1,2-trimethyl-n-propyl, 1,2,2-trimethyl-n-propyl, 1-ethyl-1-methyl-n-propyl, and 1-ethyl-2-methyl-n-propyl.

Of these, methyl is preferred.

Specific examples of the cyclic alkyl group include, but are not limited to, cycloalkyl groups such as cyclopropyl, cyclobutyl, 1-methyl-cyclopropyl, 2-methyl-cyclopropyl, cyclopentyl, 1-methyl-cyclobutyl, 2-methyl-cyclobutyl, 3-methyl-cyclobutyl, 1,2-dimethyl-cyclopropyl, 2,3-dimethyl-cyclopropyl, 1-ethyl-cyclopropyl, 2-ethylcyclopropyl, cyclohexyl, 1-methyl-cyclopentyl, 2-methyl-cyclopentyl, 3-methyl-cyclopentyl, 1-ethyl-cyclobutyl, 2-ethyl-cyclobutyl, 3-ethyl-cyclobutyl, 1,2-dimethyl-cyclobutyl, 1,3-dimethyl-cyclobutyl, 2,2-dimethyl-cyclobutyl, 2,3-dimethyl-cyclobutyl, 2,4-dimethyl-cyclobutyl, 3,3-dimethyl-cyclobutyl, 1-n-propyl-cyclopropyl, 2-n-propyl-cyclopropyl, 1-i-propyl-cyclopropyl, 2-i-propyl-cyclopropyl, 1,2,2-trimethyl-cyclopropyl, 1,2,3-trimethyl-cyclopropyl, 2,2,3-trimethyl-cyclopropyl, 1-ethyl-2-methyl-cyclopropyl, 2-ethyl-1-methyl-cyclopropyl, 2-ethyl-2-methyl-cyclopropyl, and 2-ethyl-3-methyl-cyclopropyl; and bicycloalkyl groups such as bicyclobutyl, bicyclopentyl, bicyclohexyl, bicycloheptyl, bicyclooctyl, bicyclononyl, and bicyclodecyl.

The alkenyl group may be linear-chain or branched-chain. No particular limitation is imposed on the number of carbon atoms thereof, and the number of carbon atoms is generally 2 to 40, preferably 30 or less, more preferably 20 or less, still more preferably 10 or less.

Specific examples of the alkenyl group include, but are not limited to, ethenyl, 1-propenyl, 2-propenyl, 1-methyl-1-ethenyl, 1-butenyl, 2-butenyl, 3-butenyl, 2-methyl-1-propenyl, 2-methyl-2-propenyl, 1-ethylethenyl, 1-methyl-1-propenyl, 1-methyl-2-propenyl, 1-pentenyl, 2-pentenyl, 3-pentenyl, 4-pentenyl, 1-n-propylethenyl, 1-methyl-1-butenyl, 1-methyl-2-butenyl, 1-methyl-3-butenyl, 2-ethyl-2-propenyl, 2-methyl-1-butenyl, 2-methyl-2-butenyl, 2-methyl-3-butenyl, 3-methyl-1-butenyl, 3-methyl-2-butenyl, 3-methyl-3-butenyl, 1,1-dimethyl-2-propenyl, 1-i-propylethenyl, 1,2-dimethyl-1-propenyl, 1,2-dimethyl-2-propenyl, 1-cyclopentenyl, 2-cyclopentenyl, 3-cyclopentenyl, 1-hexenyl, 2-hexenyl, 3-hexenyl, 4-hexenyl, 5-hexenyl, 1-methyl-1-pentenyl, 1-methyl-2-pentenyl, 1-methyl-3-pentenyl, 1-methyl-4-pentenyl, 1-n-butylethenyl, 2-methyl-1-pentenyl, 2-methyl-2-pentenyl, 2-methyl-3-pentenyl, 2-methyl-4-pentenyl, 2-n-propyl-2-propenyl, 3-methyl-1-pentenyl, 3-methyl-2-pentenyl, 3-methyl-3-pentenyl, 3-methyl-4-pentenyl, 3-ethyl-3-butenyl, 4-methyl-1-pentenyl, 4-methyl-2-pentenyl, 4-methyl-3-pentenyl, 4-methyl-4-pentenyl, 1,1-dimethyl-2-butenyl, 1,1-dimethyl-3-butenyl, 1,2-dimethyl-1-butenyl, 1,2-dimethyl-2-butenyl, 1,2-dimethyl-3-butenyl, 1-methyl-2-ethyl-2-propenyl, 1-s-butylethenyl, 1,3-dimethyl-1-butenyl, 1,3-dimethyl-2-butenyl, 1,3-dimethyl-3-butenyl, 1-i-butylethenyl, 2,2-dimethyl-3-butenyl, 2,3-dimethyl-1-butenyl, 2,3-dimethyl-2-butenyl, 2,3-dimethyl-3-butenyl, 2-i-propyl-2-propenyl, 3,3-dimethyl-1-butenyl, 1-ethyl-1-butenyl, 1-ethyl-2-butenyl, 1-ethyl-3-butenyl, 1-n-propyl-1-propenyl, 1-n-propyl-2-propenyl, 2-ethyl-1-butenyl, 2-ethyl-2-butenyl, 2-ethyl-3-butenyl, 1,1,2-trimethyl-2-propenyl, 1-t-butylethenyl, 1-methyl-1-ethyl-2-propenyl, 1-ethyl-2-methyl-1-propenyl, 1-ethyl-2-methyl-2-propenyl, 1-i-propyl-1-propenyl, 1-i-propyl-2-propenyl, 1-methyl-2-cyclopentenyl, 1-methyl-3-cyclopentenyl, 2-methyl-1-cyclopentenyl, 2-methyl-2-cyclopentenyl, 2-methyl-3-cyclopentenyl, 2-methyl-4-cyclopentenyl, 2-methyl-5-cyclopentenyl, 2-methylene-cyclopentyl, 3-methyl-1-cyclopentenyl, 3-methyl-2-cyclopentenyl, 3-methyl-3-cyclopentenyl, 3-methyl-4-cyclopentenyl, 3-methyl-5-cyclopentenyl, 3-methylene-cyclopentyl, 1-cyclohexenyl, 2-cyclohexenyl, and 3-cyclohexenyl.

Of these, ethenyl and 2-propenyl are preferred.

As described above, the polysiloxane (A1) includes the polyorganosiloxane (a1) and the polyorganosiloxane (a2). In curing, the alkenyl group present in the polyorganosiloxane (a1) and the hydrogen atom (Si-H group) present in the polyorganosiloxane (a2) form a cross-linking structure through hydrosilylation in the presence of the platinum group metal catalyst (A2).

The polyorganosiloxane (a1) has one or more units selected from the group consisting of unit Q', unit M', unit D', and unit T', and at least one unit selected from the group consisting of unit M', unit D', and unit T'. Two or more polyorganosiloxanes satisfying the above conditions may be used in combination as the polyorganosiloxane (a1).

Examples of preferred combinations of two or more units selected from the group consisting of unit Q', unit M', unit D', and unit T' include, but are not limited to, (unit Q' and unit M'), (unit D' and unit M'), (unit T' and unit M'), and (unit Q', unit T', and unit M').

In the case where the polyorganosiloxane (a1) includes two or more polyorganosiloxanes, examples of preferred combinations include, but are not limited to, (unit Q' and unit M') + (unit D' and unit M'; (unit T' and unit M') + (unit D' and unit M'); and (unit Q', unit T', and unit M') + (unit T' and unit M').

The polyorganosiloxane (a2) has one or more units selected from the group consisting of unit Q'', unit M'', unit D'', and unit T'', and at least one unit selected from the group consisting of unit M'', unit D'', and unit T''. Two or more polyorganosiloxanes satisfying the above conditions may be used in combination as the polyorganosiloxane (a2).

Examples of preferred combinations of two or more units selected from the group consisting of unit Q'', unit M'', unit D'', and unit T'' include, but are not limited to, (unit M" and unit D''), (unit Q'' and unit M''), and (unit Q'', unit T'', and unit M").

The polyorganosiloxane (a1) is formed of siloxane units in which an alkyl group and/or an alkenyl group is bonded to a silicon atom. The alkenyl group content of the entire substituents R^{1'} to R^{6'} is preferably 0.1 mol% to 50.0 mol%, more preferably 0.5 mol% to 30.0 mol%, and the remaining R^{1'} to R^{6'} may be alkyl groups.

The polyorganosiloxane (a2) is formed of siloxane units in which an alkyl group and/or a hydrogen atom is bonded to a silicon atom. The hydrogen atom content of the entire substituents or atoms R^{1"} to R^{6"} is preferably 0.1 mol% to 50.0 mol%, more preferably 10.0 mol% to 40.0 mol%, and the remaining R^{1"} to R^{6"} may be alkyl groups.

The polysiloxane (A1) includes the polyorganosiloxane (a1) and the polyorganosiloxane (a2). In one preferred embodiment of the present invention, the ratio by mole of alkenyl groups present in the polyorganosiloxane (a1) to hydrogen atoms forming Si-H bonds present in the polyorganosiloxane (a2) is 1.0:0.5 to 1.0:0.66.

The weight average molecular weight of each of the polyorganosiloxane (a1) and the polyorganosiloxane (a2) are generally 500 to 1,000,000, preferably 5,000 to 50,000.

In the present invention, weight average molecular weight may be determined by means of, for example, a GPC apparatus (EcoSEC, HLC-8320GPC, products of Tosoh Corporation) and GPC columns (Shodex(registered trademark), KF-803L, KF-802, and KF-801, products of Showa Denko K.K.) at a column temperature of 40°C and a flow rate of 1.0 mL/min by use of tetrahydrofuran as an eluent (extraction solvent) and polystyrene (product of Sigma-Aldrich) as a standard substance.

The polyorganosiloxane (a1) and the polyorganosiloxane (a2) contained in the adhesive composition of the present invention for use in debonding with light irradiation react with each other via hydrosilylation, to thereby form a cured film. Thus, the curing mechanism differs from the mechanism of curing mediated by, for example, silanol groups. Therefore, neither of the siloxanes of the present invention is required to have a silanol group or a functional group forming a silanol group through hydrolysis (e.g., an alkyloxy group) .

The component (A) contains the platinum group metal catalyst (A2).

The platinum-based metallic catalyst is used to accelerate hydrosilylation between alkenyl groups of the polyorganosiloxane (a1) and Si-H groups of the polyorganosiloxane (a2).

Specific examples of the platinum-based metallic catalyst include, but are not limited to, platinum catalysts such as platinum black, platinum(II) chloride, chloroplatinic acid, a reaction product of chloroplatinic acid and a monohydric alcohol, a chloroplatinic acid-olefin complex, and platinum bis(acetoacetate).

Examples of the platinum-olefin complex include, but are not limited to, a complex of platinum with divinyltetramethyldisiloxane.

The amount of platinum group metal catalyst (A2) is generally 1.0 to 50.0 ppm, with respect to the total amount of polyorganosiloxane (a1) and polyorganosiloxane (a2).

The component (A) may contain a polymerization inhibitor (A3). Through incorporation of the polymerization inhibitor into the adhesive composition of the present invention for use in debonding with light irradiation, heat curing during bonding can be suitably controlled, whereby a composition which can provide an adhesive layer having an excellent bonding/debonding property can be produced at high reproducibility.

No particular limitation is imposed on the polymerization inhibitor, so long as it can suppress the progress of hydrosilylation. Specific examples of the polymerization inhibitor include, but are not limited to, optionally aryl group-substituted alkynylalkyl alcohols such as 1-ethynyl-1-cyclohexanol and 1,1-diphenyl-2-propyn-1-ol.

Generally, the amount of polymerization inhibitor with respect to the polyorganosiloxane (a1) and the polyorganosiloxane (a2) is 1,000.0 ppm or more from the viewpoint of attaining the effect, and 10,000.0 ppm or less from the viewpoint of preventing excessive suppression of hydrosilylation.

The adhesive composition of the present invention for use in debonding with light irradiation may contain a component (B) containing at least one species selected from the group consisting of a component containing an epoxy-modified polyorganosiloxane, a component containing a methyl-group-containing polyorganosiloxane, and a component a phenyl-group-containing polyorganosiloxane. Through incorporation of such a component (B) into the adhesive composition of the present invention for use in debonding with light irradiation, the formed adhesive layer can be suitably peeled off at high reproducibility.

Among such components (B), a component containing a methyl-group-containing polyorganosiloxane is preferred.

The epoxy-modified polyorganosiloxane includes, for example, such a siloxane containing a siloxane unit represented by R²¹⁰R²²⁰SiO_{2/2} (unit D²⁰⁰), preferably a siloxane containing a siloxane unit represented by R¹¹R¹²SiO_{2/2} (unit D¹⁰).

R¹¹ is a group bonded to a silicon atom and represents an alkyl group, and R¹² is a group bonded to a silicon atom and represents an epoxy group or an organic group containing an epoxy group. Specific examples of the alkyl group include those as exemplified above.

Also, the epoxy group in the organic group containing an epoxy group may be an independent epoxy group which does not condense with another ring structure, or may be an epoxy group forming a condensed ring with another ring structure (e.g., a 1,2-epoxycyclohexyl group).

Specific example of the organic group containing an epoxy group include, but are not limited to, 3-glycidoxypropyl and 2-(3,4-epoxycyclohexyl)ethyl.

In the present invention, examples of preferred epoxy-modified polyorganosiloxanes include, but are not limited to, epoxy-modified polydimethylsiloxane.

The epoxy-modified polyorganosiloxane contains the aforementioned siloxane unit (unit D¹⁰), but may also contain the aforementioned unit Q, unit M and/or unit T, in addition to unit D¹⁰.

In one preferred embodiment of the present invention, specific examples of the epoxy-modified polyorganosiloxane include polyorganosiloxane formed only of unit D¹⁰, polyorganosiloxane formed of unit D¹⁰ and unit Q, polyorganosiloxane formed of unit D¹⁰ and unit M, polyorganosiloxane formed of unit D¹⁰ and unit T, polyorganosiloxane formed of unit D¹⁰, unit Q, and unit M, polyorganosiloxane formed of unit D¹⁰, unit M, and unit T, and polyorganosiloxane formed of unit D¹⁰, unit Q, unit M, and unit T.

The epoxy-modified polyorganosiloxane is preferably an epoxy-modified polydimethylsiloxane having an epoxy value of 0.1 to 5. The weight average molecular weight thereof is generally 1,500 to 500,000, but preferably 100,000 or lower, for the purpose of suppression of deposition in the adhesive.

Specific examples of the epoxy-modified polyorganosiloxane include, but are not limited to, CMS-227 (product of Gelest Inc., weight average molecular weight: 27,000) represented by formula (A-1), ECMS-327 (product of Gelest Inc., weight average molecular weight: 28,800) represented by formula (A-2), KF-101 (product of Shin-Etsu Chemical Co., Ltd., weight average molecular weight: 31,800) represented by formula (A-3), KF-1001 (product of Shin-Etsu Chemical Co., Ltd., weight average molecular weight: 55,600) represented by formula (A-4), KF-1005 (product of Shin-Etsu Chemical Co., Ltd., weight average molecular weight: 11,500) represented by formula (A-5), X-22-343 (product of Shin-Etsu Chemical Co., Ltd., weight average molecular weight: 2,400) represented by formula (A-6), BY16-839 (product of Dow Corning, weight average molecular weight: 51,700) represented by formula (A-7), and ECMS-327 (product of Gelest Inc., weight average molecular weight: 28,800) represented by formula (A-8). 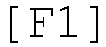 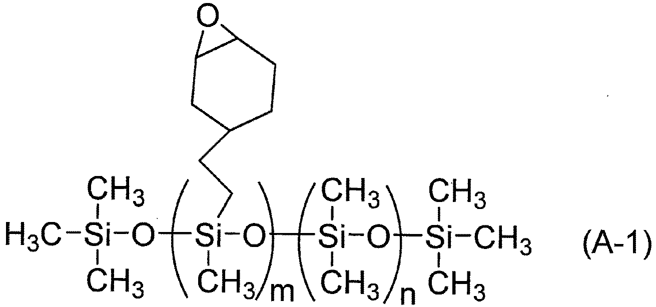 (Each of m and n represents the number of repeating units.) 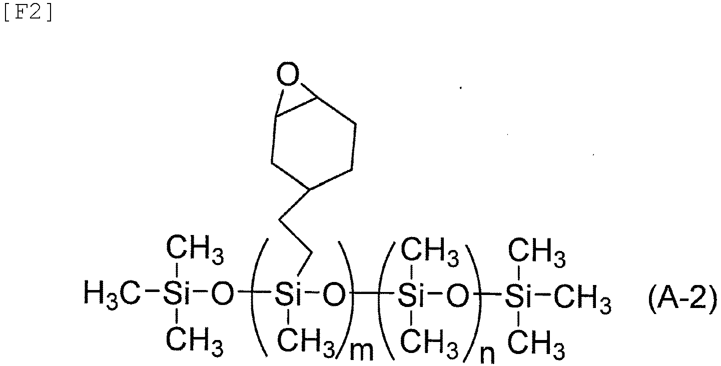 (Each of m and n represents the number of repeating units.) 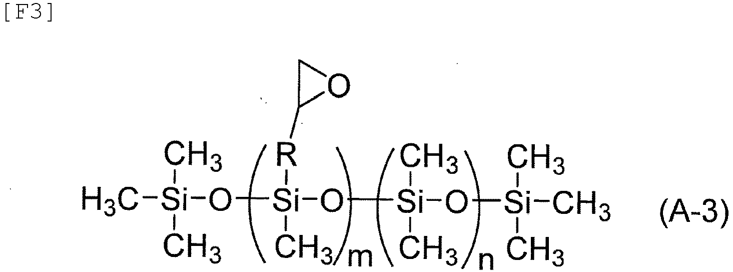 (Each of m and n represents the number of repeating units. R represents a C1 to C10 alkylene group.) 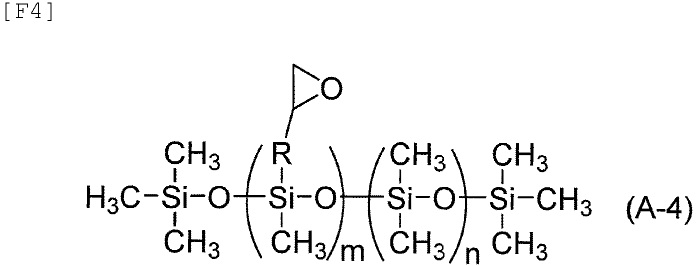 (Each of m and n represents the number of repeating units. R represents a C1 to C10 alkylene group.) 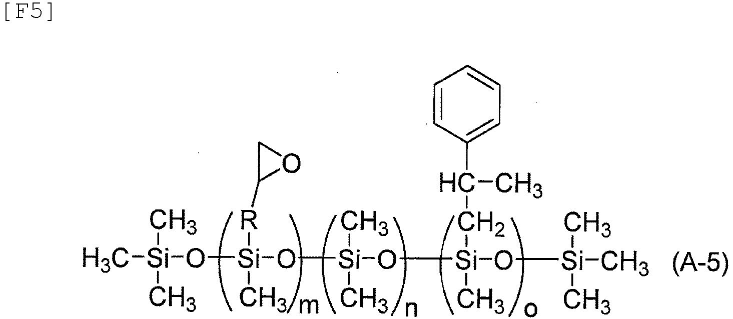 (Each of m, n and o represents the number of repeating units. R represents a C1 to C10 alkylene group.) 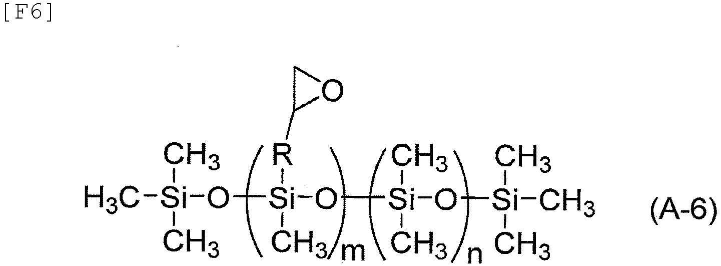 (Each of m and n represents the number of repeating units. R represents a C1 to C10 alkylene group.) 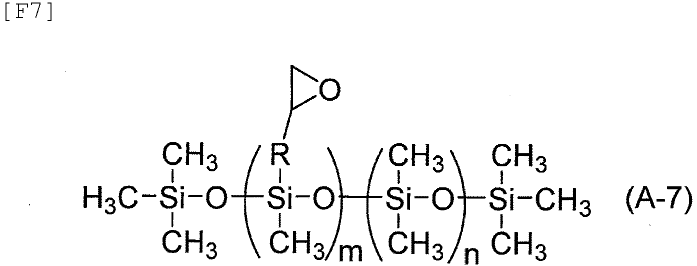 (Each of m and n represents the number of repeating units. R represents a C1 to C10 alkylene group.) 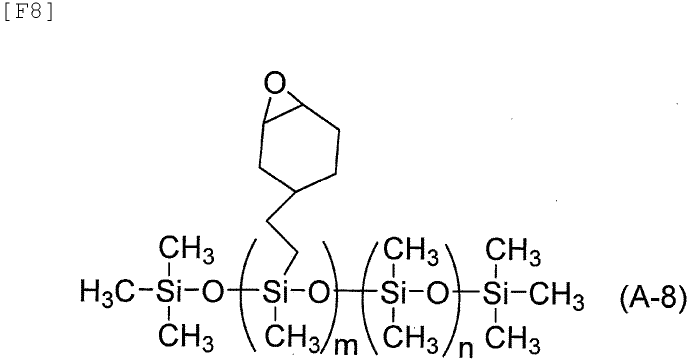 (Each of m and n represents the number of repeating units.)

The methyl-group-containing polyorganosiloxane includes, for example, a siloxane containing a siloxane unit represented by R²¹⁰R²²⁰SiO_{2/2} (unit D²⁰⁰), preferably a siloxane containing a siloxane unit represented by R²¹R²¹SiO_{2/2} (unit D²⁰).

Each of R²¹⁰ and R²²⁰ is a group bonded to a silicon atom and represents an alkyl group. At least one of R²¹⁰ and R²²⁰ is a methyl group. Specific examples of the alkyl group include those as exemplified above.

R²¹ is a group bonded to a silicon atom and represents an alkyl group. Specific examples of the alkyl group include those as exemplified above. R²¹ is preferably a methyl group.

In the present invention, examples of preferred methyl-group-containing polyorganosiloxanes include, but are not limited to, polydimethylsiloxane.

The methyl-group-containing polyorganosiloxane contains the aforementioned siloxane unit (unit D²⁰⁰ or unit D²⁰), but may also contain the aforementioned unit Q, unit M and/or unit T, in addition to unit D²⁰⁰ or unit D²⁰,

In one embodiment of the present invention, specific examples of the methyl-group-containing polyorganosiloxane include polyorganosiloxane formed only of unit D²⁰⁰, polyorganosiloxane formed of unit D²⁰⁰ and unit Q, polyorganosiloxane formed of unit D²⁰⁰ and unit M, polyorganosiloxane formed of unit D²⁰⁰ and unit T, polyorganosiloxane formed of unit D²⁰⁰, unit Q, and unit M, polyorganosiloxane formed of unit D²⁰⁰, unit M, and unit T, and polyorganosiloxane formed of unit D²⁰⁰, unit Q, unit M, and unit T.

In one preferred embodiment of the present invention, specific examples of the methyl-group-containing polyorganosiloxane include polyorganosiloxane formed only of unit D²⁰, polyorganosiloxane formed of unit D²⁰ and unit Q, polyorganosiloxane formed of unit D²⁰ and unit M, polyorganosiloxane formed of unit D²⁰ and unit T, polyorganosiloxane formed of unit D²⁰, unit Q, and unit M, polyorganosiloxane formed of unit D²⁰, unit M, and unit T, and polyorganosiloxane formed of unit D²⁰, unit Q, unit M, and unit T.

The viscosity of the methyl-group-containing polyorganosiloxane is generally 1,000 to 2,000,000 mm²/s, preferably 10,000 to 1,000,000 mm²/s. The methyl-group-containing polyorganosiloxane is typically dimethylsilicone oil formed of polydimethylsiloxane. The value of the viscosity is a kinematic viscosity (cSt (=mm²/s)). The kinematic viscosity may be measured by means of a kinematic viscometer. Alternatively, the kinematic viscosity may also calculated by dividing viscosity (mPa·s) by density (g/cm³). In other words, the kinematic viscosity may be determined from a viscosity as measured at 25°C by means of an E-type rotational viscometer and a density. The calculation formula is kinematic viscosity (mm²/s) = viscosity (mPa·s)/density (g/cm³).

Specific examples of the methyl-group-containing polyorganosiloxane include, but are not limited to, WACKER(registered trademark) SILICONE FLUID AK series (products of WACKER) and dimethylsilicone oils (KF-96L, KF-96A, KF-96, KF-96H, KF-69, KF-965, and KF-968) and cyclic dimethylsilicone oil (KF-995) (products of Shin-Etsu Chemical Co., Ltd.).

Examples of the phenyl-group-containing polyorganosiloxane include a siloxane containing a siloxane unit represented by R³¹R³²SiO_{2/2} (unit D³⁰).

R³¹ is a group bonded to a silicon atom and represents a phenyl group or an alkyl group, and R³² is a group bonded to a silicon atom and represents a phenyl group. Specific examples of the alkyl group include those as exemplified above. R³¹ is preferably a methyl group.

The phenyl-group-containing polyorganosiloxane contains the aforementioned siloxane unit (unit D³⁰), but may also contain the aforementioned unit Q, unit M and/or unit T, in addition to unit D³⁰.

In one preferred embodiment of the present invention, specific examples of the phenyl-group-containing polyorganosiloxane include polyorganosiloxane formed only of unit D³⁰, polyorganosiloxane formed of unit D³⁰ and unit Q, polyorganosiloxane formed of unit D³⁰ and unit M, polyorganosiloxane formed of unit D³⁰ and unit T, polyorganosiloxane formed of unit D³⁰, unit Q, and unit M, polyorganosiloxane formed of unit D³⁰, unit M, and unit T, and polyorganosiloxane formed of unit D³⁰, unit Q, unit M, and unit T.

The weight average molecular weight of the phenyl-group-containing polyorganosiloxane is generally 1,500 to 500,000, but preferably 100,000 or lower, for the purpose of suppression of deposition in the adhesive and for other reasons.

Specific examples of the phenyl-group-containing polyorganosiloxane include, but are not limited to, PMM-1043 (product of Gelest Inc., weight average molecular weight: 67,000, viscosity: 30,000 mm²/s) represented by formula (C-1), PMM-1025 (product of Gelest Inc., weight average molecular weight: 25,200, viscosity: 500 mm²/s) represented by formula (C-2), KF50-3000CS (product of Shin-Etsu Chemical Co., Ltd., weight average molecular weight: 39,400, viscosity: 3,000 mm²/s) represented by formula (C-3), TSF431 (product of MOMENTIVE, weight average molecular weight: 1,800, viscosity: 100 mm²/s) represented by formula (C-4), TSF433 (product of MOMENTIVE, weight average molecular weight: 3,000, viscosity: 450 mm²/s) represented by formula (C-5), PDM-0421 (product of Gelest Inc., weight average molecular weight: 6,200, viscosity: 100 mm²/s) represented by formula (C-6), and PDM-0821 (product of Gelest Inc., weight average molecular weight: 8,600, viscosity: 125 mm²/s) represented by formula (C-7). 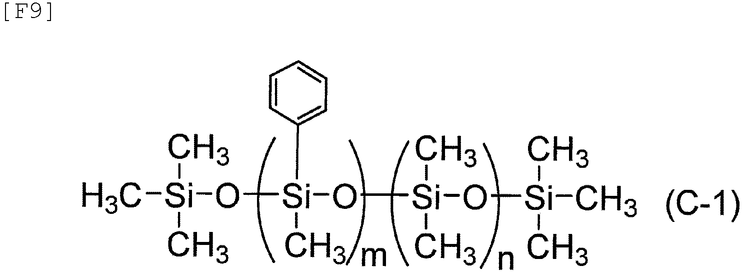 (Each of m and n represents the number of repeating units.) 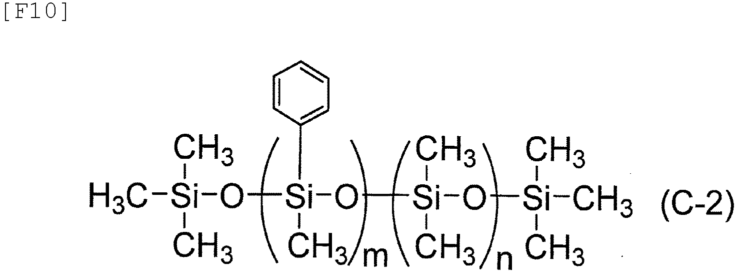 (Each of m and n represents the number of repeating units.) 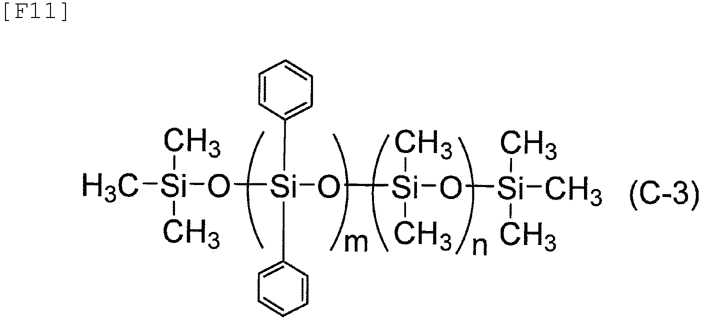 (Each of m and n represents the number of repeating units.) 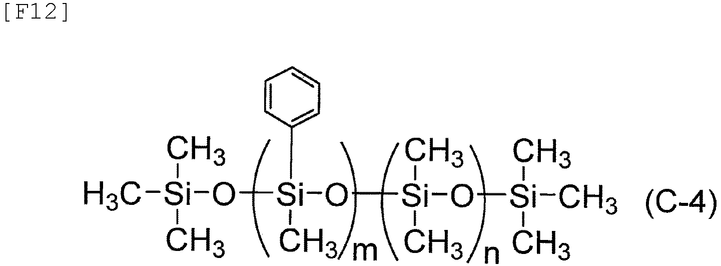 (Each of m and n represents the number of repeating units.) 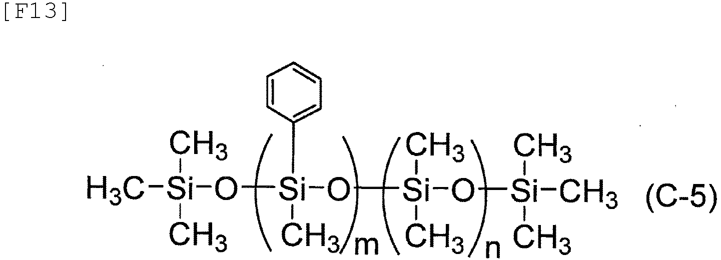 (Each of m and n represents the number of repeating units.) 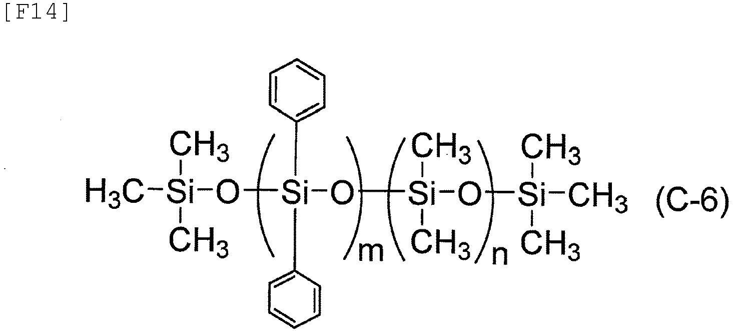 (Each of m and n represents the number of repeating units.) 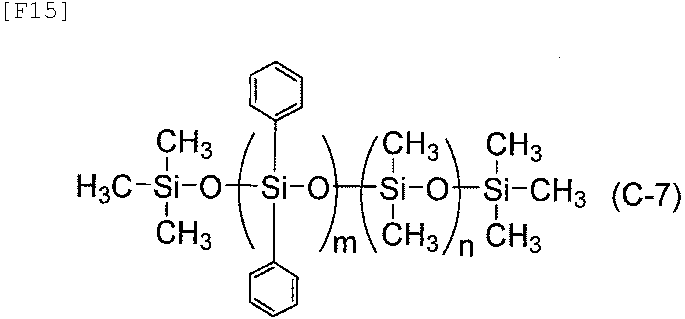 (Each of m and n represents the number of repeating units.)

The adhesive composition of the present invention for use in debonding with light irradiation contains the components (A) and (B) at any compositional ratio. In consideration of the balance between bonding performance and debonding performance, the compositional ratio (mass%) of component (A) to component (B) is preferably 99.995:0.005 to 30:70, more preferably 99.9:0.1 to 75:25.

For the purpose of adjusting the viscosity or for other reasons, the adhesive composition for use in debonding with light irradiation may contain a solvent. Specific examples of the solvent include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone. These solvents may be used singly or in combination of two or more species.

In the case where the adhesive composition of the present invention for use in debonding with light irradiation contains a solvent, the solvent content is appropriately adjusted in consideration of a target viscosity of the adhesive, the application method to be employed, the thickness of the formed thin film, etc. The solvent content of the entire composition is about 10 to about 90 mass%.

The adhesive composition of the present invention for use in debonding with light irradiation generally has a viscosity (25°C) of 500 to 20,000 mPa·s, preferably 1,000 to 5,000 mPa·s. The viscosity of the adhesive composition of the present invention for use in debonding with light irradiation may be controlled by modifying the type and formulation of the organic solvent used, the film-forming component concentration, etc., in consideration of various factors such as the coating method employed and the target film thickness. Notably, the term "film-forming component" used in the present invention refers to any component other than solvent.

The adhesive composition of the present invention for use in debonding with light irradiation may be produced by mixing film-forming components with solvent. However, in the case where no solvent is used, the adhesive composition of the present invention for use in debonding with light irradiation may be produced by mixing film-forming components.

No particular limitation is imposed on the sequential order of mixing, so long as the adhesive composition of the present invention for use in debonding with light irradiation can be easily produced at high reproducibility. One possible example of the production method includes dissolving or dispersing all film-forming components in a solvent. Another possible example of the production method includes dissolving or dispersing a part of film-forming components in a solvent, dissolving or dispersing the other film-forming components in another solvent, and mixing the thus-obtained two solutions. In this case, if required, a part of the solvent or a film-forming component having high dissolvability may be added in a final stage. So long as the relevant components are not decomposed or denatured in preparation of the composition, the mixture may be appropriately heated.

In the present invention, in order to remove foreign substances present in the adhesive composition for use in debonding with light irradiation, the composition may be filtered through a sub-micrometer filter or the like in the course of production of the composition or after mixing all the components.

As mentioned above, the laminate of the present invention includes a first substrate formed of a semiconductor-forming substrate, a second substrate which is formed of a support substrate and which allows passage of laser light, and an adhesive layer which is a cured film formed by use of the aforementioned adhesive composition for use in debonding with light irradiation. Thus, no particular limitation is imposed on the laminate production method, so long as the adhesive layer formed of a cured film is produced by use of the aforementioned adhesive composition for use in debonding with light irradiation. From the viewpoint of attaining the effects of the present invention at high reproducibility or for other reasons, the laser transmittance of the adhesive layer is preferably 99% or lower, more preferably 90% or lower, still more preferably 85% or lower, yet more preferably 80% or lower, and the lower limit of the transmittance is 0% (i.e., complete laser absorption). However, no particular limitation is imposed on the transmittance, so long as the adhesive layer can absorb laser light at a dose required for debonding.

In one preferred embodiment of the present invention, the laminate production method of the present invention includes a first step of applying the adhesive composition for use in debonding with light irradiation onto a surface of the first substrate or the second substrate, to thereby form an adhesive coating layer; and a second step of bonding the first substrate to the second substrate by the mediation of the adhesive coating layer; applying a load to the first substrate and the second substrate in a thickness direction, to thereby closely adhere the first layer, the adhesive coating layer, and the second layer, while at least one of a heat treatment and a reduced pressure treatment is performed; and then performing a post-heat treatment. Through the post-heat treatment in the second step, the adhesive coating layer is suitably cured in a final stage, to thereby provide an adhesive layer.

In one embodiment, the first substrate is a wafer, and the second substrate is a support. The adhesive composition for use in debonding with light irradiation may be applied to either of the first or second substrate, or both of the first and second substrates. Among two substrates, the first substrate is preferred.

No particular limitation is imposed on the wafer, and an example of the wafer is a silicon wafer or a glass wafer having a diameter of about 300 mm and a thickness of about 770 µm.

No particular limitation is imposed on the support (carrier), so long as the support allows passage of laser light. The transmittance of the support is generally 80% or higher, preferably 90% or higher. Examples of the support include, but are not limited to, is a silicon wafer having a diameter of about 300 mm and a thickness of about 700 µm.

As used herein, the term "laser light" refers to laser light employed in the below-mentioned debonding (peeling) step. The wavelength of the laser light is generally 190 nm to 600 nm. From the viewpoints of suitably performing debonding at high reproducibility and the like, the wavelength is preferably 250 nm or longer, more preferably 300 nm or longer, and preferably 580 nm or shorter, more preferably 560 nm or shorter. Laser light having a wavelength of, for example, 308 nm, 355 nm, or 532 nm can suitably debond the laminate of the present invention.

The thickness of the adhesive coating layer is generally 5 to 500 µm. However, the thickness is preferably 10 µm or greater, more preferably 20 µm or greater, still more preferably 30 µm or greater, from the viewpoint of maintaining the film strength, and it is preferably 200 µm or less, more preferably 150 µm or less, still more preferably 120 µm or less, yet more preferably 70 µm or less, from the viewpoint of avoiding variation in uniformity of the film thickness.

No particular limitation is imposed on the application method, and spin coating is generally employed. In an alternative method, a coating film is formed through spin coating or a similar technique, and the sheet-form coating film is attached. The concepts of the application method and the coating film of the invention also encompasses the alternative method and coating film.

The temperature of heating the coated adhesive composition for use in debonding with light irradiation cannot definitely be determined, since the temperature varies depending on the thickness, etc. of the adhesive layer. However, the heating temperature is generally 80°C or higher, preferably 150°C or lower, from the viewpoint of prevention of excessive curing. The time of heating is generally 30 seconds or longer, preferably 1 minute or longer, for securing temporary bonding performance. Also, the heating time is generally 5 minutes or shorter, preferably 2 minutes or shorter, from the viewpoint of suppressing deterioration of the adhesive layer and other members. Notably, heating may be performed by means of a hot plate, an oven, or the like.

In the reduced pressure treatment, the two substrates and the adhesive coating layer disposed therebetween are placed in an atmosphere at 10 Pa to 10,000 Pa. The time of the reduced pressure treatment is generally 1 to 30 minutes.

In one preferred embodiment of the present invention, the two substrates and the adhesive coating layer disposed therebetween are bonded together preferably through a heat treatment, more preferably through a heat treatment in combination with a reduced pressure treatment.

No particular limitation is imposed on the load which is applied to the first substrate and the second substrate in a thickness direction, so long as the first substrate, the second substrate, and the layer therebetween are not damaged, and these elements are closely adhered. The load is generally 10 to 1,000 N.

The temperature of post-heating is preferably 120°C or higher from the viewpoint of attaining sufficient curing rate, and preferably 260°C or lower from the viewpoint of preventing deterioration of the substrates and the adhesives. The heating time is generally 1 minute or longer from the viewpoint of achieving suitable joining of a wafer through curing, preferably 5 minutes or longer from the viewpoint of, for example, stability in physical properties of the adhesives. Also, the heating time is generally 180 minutes or shorter, preferably 120 minutes or shorter, from the viewpoint of avoiding, for example, an adverse effect on the adhesive layers due to excessive heating. Heating may be performed by means of a hot plate, an oven, or the like. Notably, a purpose of performing post-heating is to, for example, more suitably cure the adhesive (A).

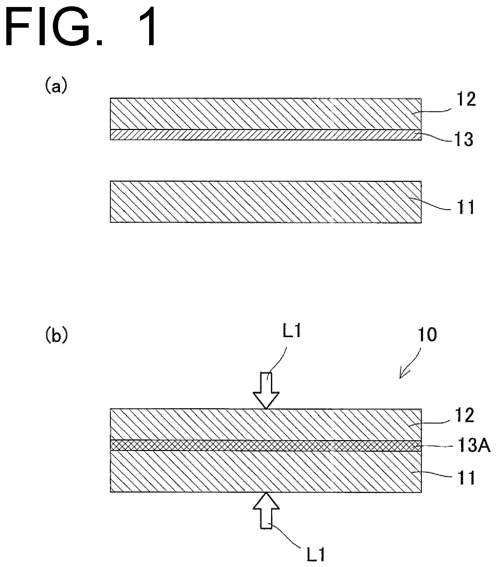

FIG. 1 schematically shows the laminate production method of the present invention. As shown in FIG. 1, a first substrate 11 and a second substrate 12 are provided. In one specific procedure, there is carried out a first step of applying the adhesive composition for use in debonding with light irradiation onto a surface of the second substrate 12, to thereby form an adhesive coating layer 13 (FIG. 1(a)). Subsequently, a second step is carried out. Specifically, the first substrate 11 is adhered to the second substrate 12 by the mediation of the adhesive coating layer 13. A load L1 is applied to the first substrate and the second substrate in a thickness direction, while at least one of a heat treatment and a reduced pressure treatment are performed. Through this step, the two layers and the layer therebetween are closely adhered to one another. Then, a post-heat treatment is performed, to thereby finally produce a laminate 10 formed by the mediation of the adhesive layer 13A (FIG. 1(b)).

According to the laminate debonding method of the present invention, after completion of production of the laminate of the present invention and a specific processing and the like, the laminate is irradiated with the laser light from the second substrate side, to thereby debond the second substrate.

As used herein, the term "processing" refers to, for example, a processing of a surface opposite the circuit-furnished surface of a wafer; e.g., a thinning of a wafer by polishing the backside thereof. Thereafter, through silicon vias (TSVs) and the like are formed, and the thinned wafer is removed from the support. A plurality of such wafers are stacked to form a wafer laminate, to thereby complete 3-dimensional mounting. Before or after the above process, a backside electrode and the like are formed on the wafer. When thinning of a wafer and the TSV process are performed, a thermal load of 250 to 350°C is applied to the laminate bonded to the support. The laminate of the present invention including the adhesive layers has heat resistance to the load.

The processing is not limited to the aforementioned process and includes, for example, a semiconductor part mounting process in the case where a wafer is temporarily bonded to a support for supporting a substrate on which semiconductor parts are to be mounted.

In one specific embodiment, when the backside surface (a surface opposite the circuit-furnished surface) of a wafer having a diameter of about 300 mm and a thickness of about 770 µm is polished, the thickness of the wafer can be reduced to about 80 µm to about 4 µm.

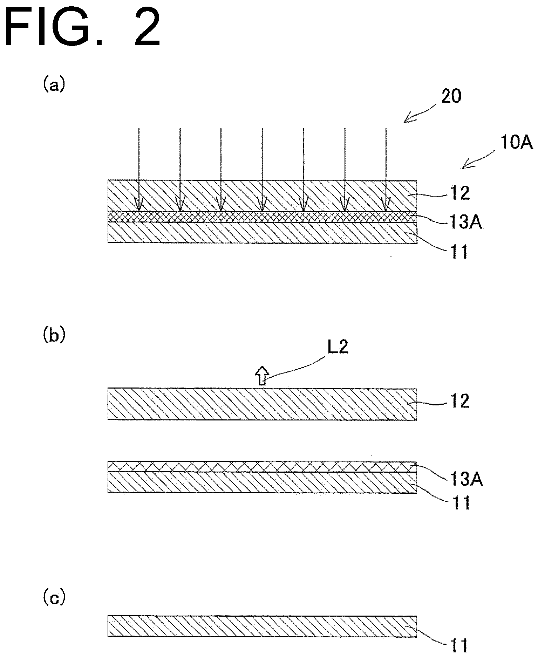

FIG. 2 is a schematic view for illustrating an example of the laminate debonding method of the present invention.

FIG. 2(a) shows a laminate 10A which has received a certain processing. The laminate 10A is irradiated with laser light 20 from a second substrate 12 side. When the adhesive layer 13A is irradiated with the laser light 20, the adhesive layer 13A is degraded through decomposition or the like, whereby the adhesiveness considerably decreases. As a result, the adhesive layer becomes peelable.

Then, as shown in FIG. 2(b), when the second substrate 12 is detached from the first substrate 11. In this case, since the adhesive layer 13A has been degraded to have a considerably reduced adhesiveness, the second substrate 12 is easily detached from the first substrate 11 by, for example, pulling up with small external force (L2).

Finally, a portion of the adhesive layer 13A remaining on the first substrate 11 is removed by use of a cleaner formed of, for example, an organic solvent, thereby yielding the first substrate 11 which has been processed (e.g., thinned) (FIG. 2(c)).

As described above, in the laminate 10 of the present invention, the components of the laminate are bonded by the adhesive layer 13A formed from the adhesive composition of the present invention for use in debonding with light irradiation. Thus, when the laminate is irradiated with the laser light 20, the second substrate 12 can be easily detached from the first substrate 11 and the adhesive layer 13A.

Notably, the entire area of the adhesive layer 13A is not necessarily irradiated with the laser light 20. Even when the adhesive layer 13 has both a laser light 20-irradiated area and a laser light 20-non-irradiated area, it is sufficient that the adhesiveness of the entire adhesive layer 13A is satisfactorily reduced. Under such conditions, the second substrate 12 can be easily separated, through application of small external force (e.g., pulling), from the laminate 10. The ratio of the laser light 20-irradiated area to the laser light 20-non-irradiated area and the locational distribution of the two areas vary depending on the adhesive composition for use in debonding with light irradiation and for forming the adhesive layer 13, the thickness of the adhesive layer 13A, the intensity of irradiation laser light 20, and other factors. However, those skilled in the art can set appropriate conditions, without carrying out excessive trial-and-error procedures. For example, a laser light-non-irradiated area may be provided adjacent to a laser light-irradiated area with the same width as that of the laser light.

Thus, even when only a part of the adhesive layer 13A is irradiated with laser light, the second substrate 12 can be separated. As a result, the total time for applying the laser light 20 to the laminate can be shortened, whereby the time for debonding can be shortened. Finally, production efficiency can be enhanced.

### Examples

(1) Agitator: planetary centrifugal mixer ARE-500 (product of Thinky Corporation)
(2) Viscometer: rotary viscometer TVE-22H (product of Toki Sangyo Co., Ltd)
(3) Transmittance Measurement: ultraviolet and visible spectrophotometer UV2550 (product of Shimadzu Corporation)
(4) Vacuum bonding apparatus: manual bonder (product of Suess Microtec SE)
(5) 308 nm Laser irradiation apparatus: 308 nm laser irradiation apparatus (product of Suess Microtec SE)
(6) Infrared radiation thermometer: infrared radiation thermometer 835-H1 (product of Testo)
(7) 532 nm Laser irradiation apparatus: LT-2137 (product of Lotus-TII)

### [1] Preparation of compositions

### [Preparation Example 1]

To a 600-mL container dedicated for an agitator, an MQ resin having vinyl groups (product of WACKER Chemie AG) (95 g) serving as polysiloxane (a1), p-menthane (product of Nippon Terpene Chemicals, Inc.) (93.4 g) serving as a solvent, and 1,1-diphenyl-2-propyn-1-ol (product of Tokyo Chemical Industry Co., Ltd.) (0.41 g) serving as a polymerization inhibitor (A3) were added, and the mixture was agitated by means of an agitator for 5 minutes.

To the thus-prepared mixture, there were added linear-chain polydimethylsiloxane having Si-H groups (viscosity: 100 mPa·s) (product of WACKER Chemie AG) serving as polysiloxane (a2), linear-chain polydimethylsiloxane having vinyl groups (viscosity: 200 mPa·s) (product of WACKER Chemie AG) (29.5 g) serving as polysiloxane (a1), polyorganosiloxane (i.e., polydimethylsiloxane) (viscosity: 1,000,000 mm²/s) (AK1000000, product of WACKER Chemie AG) serving as a component (B), and 1-ethynyl-1-cyclohexanol (product of WACKER Chemie AG) (0.41 g) serving as a polymerization inhibitor (A3), and the resultant mixture was agitated by means of an agitator for 5 minutes.

Separately, a platinum catalyst (product of WACKER Chemie AG) (0.20 g) serving as a platinum group metal catalyst (A2) and linear-chain polydimethylsiloxane having vinyl groups (viscosity: 1,000 mPa·s) (product of WACKER Chemie AG) (17.7 g) serving as polysiloxane (a1) were agitated by means of an agitator for 5 minutes. A portion (14.9 g) of the thus-agitated product was added to the above mixture, and the resultant mixture was agitated by means of an agitator for 5 minutes.

Finally, the product mixture was filtered through a nylon filter (300 mesh), to thereby prepare a precursor composition having a viscosity of 2,400 mPa·s.

### [Preparation Example 2]

To a 600-mL container dedicated for an agitator, an MQ resin having vinyl groups (product of WACKER Chemie AG) (95 g) serving as polysiloxane (a1), p-menthane (product of Nippon Terpene Chemicals, Inc.) (93.4 g) serving as a solvent, and 1,1-diphenyl-2-propyn-1-ol (product of Tokyo Chemical Industry Co., Ltd.) (0.41 g) serving as a polymerization inhibitor (A3) were added, and the mixture was agitated by means of an agitator for 5 minutes.

To the thus-prepared mixture, there were added linear-chain polydimethylsiloxane having Si-H groups (viscosity: 100 mPa·s) (product of WACKER Chemie AG) serving as polysiloxane (a2), linear-chain polydimethylsiloxane having vinyl groups (viscosity: 200 mPa·s) (product of WACKER Chemie AG) (23.6 g) serving as polysiloxane (a1), polyorganosiloxane (i.e., polydimethylsiloxane) (viscosity: 1,000,000 mm²/s) (AK1000000, product of WACKER Chemie AG) serving as a component (B), and 1-ethynyl-1-cyclohexanol (product of WACKER Chemie AG) (0.41 g) serving as a polymerization inhibitor (A3), and the resultant mixture was agitated by means of an agitator for 5 minutes.

Separately, a platinum catalyst (product of WACKER Chemie AG) (0.20 g) serving as a platinum group metal catalyst (A2) and linear-chain polydimethylsiloxane having vinyl groups (viscosity: 1,000 mPa·s) (product of WACKER Chemie AG) (17.7 g) serving as polysiloxane (a1) were agitated by means of an agitator for 5 minutes. A portion (14.9 g) of the thus-agitated product was added to the above mixture, and the resultant mixture was agitated by means of an agitator for 5 minutes.

Finally, the product mixture was filtered through a nylon filter (300 mesh), to thereby prepare a precursor composition.

### [Preparation Example 3]

To a 600-mL container dedicated for an agitator, an MQ resin having vinyl groups (product of WACKER Chemie AG) (95 g) serving as polysiloxane (a1), p-menthane (product of Nippon Terpene Chemicals, Inc.) (93.4 g) serving as a solvent, and 1,1-diphenyl-2-propyn-1-ol (product of Tokyo Chemical Industry Co., Ltd.) (0.41 g) serving as a polymerization inhibitor (A3) were added, and the mixture was agitated by means of an agitator for 5 minutes.

To the thus-prepared mixture, there were added linear-chain polydimethylsiloxane having Si-H groups (viscosity: 100 mPa·s) (product of WACKER Chemie AG) serving as polysiloxane (a2), linear-chain polydimethylsiloxane having vinyl groups (viscosity: 200 mPa·s) (product of WACKER Chemie AG) (17.7 g) serving as polysiloxane (a1), polyorganosiloxane (i.e., polydimethylsiloxane) (viscosity: 1,000,000 mm²/s) (AK1000000, product of WACKER Chemie AG) serving as a component (B), and 1-ethynyl-1-cyclohexanol (product of WACKER Chemie AG) (0.41 g) serving as a polymerization inhibitor (A3), and the resultant mixture was agitated by means of an agitator for 5 minutes.

Separately, a platinum catalyst (product of WACKER Chemie AG) (0.20 g) serving as a platinum group metal catalyst (A2) and linear-chain polydimethylsiloxane having vinyl groups (viscosity: 1,000 mPa·s) (product of WACKER Chemie AG) (17.7 g) serving as polysiloxane (a1) were agitated by means of an agitator for 5 minutes. A portion (14.9 g) of the thus-agitated product was added to the above mixture, and the resultant mixture was agitated by means of an agitator for 5 minutes.

Finally, the product mixture was filtered through a nylon filter (300 mesh), to thereby prepare a precursor composition.

### [Preparation Example 4]

To a 600-mL container dedicated for an agitator, an MQ resin having vinyl groups (product of WACKER Chemie AG) (95 g) serving as polysiloxane (a1), p-menthane (product of Nippon Terpene Chemicals, Inc.) (93.4 g) serving as a solvent, and 1,1-diphenyl-2-propyn-1-ol (product of Tokyo Chemical Industry Co., Ltd.) (0.41 g) serving as a polymerization inhibitor (A3) were added, and the mixture was agitated by means of an agitator for 5 minutes.

To the thus-prepared mixture, there were added linear-chain polydimethylsiloxane having Si-H groups (viscosity: 100 mPa·s) (product of WACKER Chemie AG) serving as polysiloxane (a2), linear-chain polydimethylsiloxane having vinyl groups (viscosity: 200 mPa·s) (product of WACKER Chemie AG) (11.8 g) serving as polysiloxane (a1), polyorganosiloxane (i.e., polydimethylsiloxane) (viscosity: 1,000,000 mm²/s) (AK1000000, product of WACKER Chemie AG) serving as a component (B), and 1-ethynyl-1-cyclohexanol (product of WACKER Chemie AG) (0.41 g) serving as a polymerization inhibitor (A3), and the resultant mixture was agitated by means of an agitator for 5 minutes.

Separately, a platinum catalyst (product of WACKER Chemie AG) (0.20 g) serving as a platinum group metal catalyst (A2) and linear-chain polydimethylsiloxane having vinyl groups (viscosity: 1,000 mPa·s) (product of WACKER Chemie AG) (17.7 g) serving as polysiloxane (a1) were agitated by means of an agitator for 5 minutes. A portion (14.9 g) of the thus-agitated product was added to the above mixture, and the resultant mixture was agitated by means of an agitator for 5 minutes.

Finally, the product mixture was filtered through a nylon filter (300 mesh), to thereby prepare a precursor composition.

### [Example 1-1]

The precursor composition produced in Preparation Example 1-1 (100 g) and carbon black (KS-4, product of Pacem Energy Ltd. (Shanghai Exchange Market)) (5 g) were added to a 350-mL container dedicated for an agitator, and the mixture was agitated by means of an agitator for 5 minutes, to thereby yield an adhesive composition of Example 1-1 for use in debonding with light irradiation.

### [Example 1-2 and Example 1-3]

The procedure of Example 1-1 was repeated, except that the amount of carbon black was changed to 10 g and 15 g, to thereby yield adhesive compositions of Examples 1-2 and 1-3 for use in debonding with light irradiation.

### [Example 1-4]

The precursor composition produced in Preparation Example 1 and carbon black (KS-4, product of Pacem Energy Ltd. (Shanghai Exchange Market)) were added to a 350-mL container dedicated for an agitator. The amounts of the two ingredients were tuned such that the amount of added carbon black per 100 g of the film-forming components contained in the precursor composition produced in Preparation Example 1 was adjusted to 10 g. The mixture was agitated by means of an agitator for 5 minutes, to thereby yield an adhesive composition of Example 7-1 for use in debonding with light irradiation.

### [Examples 1-5 to 1-7]

The procedure of Example 1-4 was repeated, except that the precursor compositions obtained in Preparation Examples 2 to 4 were respectively used instead of the precursor composition of Preparation Example 1, to thereby yield adhesive compositions of Examples 1-5 to 1-7 for use in debonding with light irradiation.

### [Comparative Example 1-1]

A silicone material not curable through hydrosilylation (Swanbond 102, product of Takada Chemical Products Mfg. Co., Ltd.) (20 g) and carbon black (KS-4, product of Pacem Energy Ltd. (Shanghai Exchange Market)) (1 g) were added to a 50-mL screw vial, and the mixture was agitated for 5 minutes by means of an agitator, to thereby yield a composition of Comparative Example 1-1.

### [2] Formation of thin film and measurement of transmittance

### [Example 2-1]

The adhesive composition for use in debonding with light irradiation produced in Example 1-1 was diluted with menthane. The thus-diluted composition was applied onto a quartz substrate by means of a spin-coater and heated at 120°C for 1 minute and then 200°C for 10 minutes on a hot plate, to thereby form a thin film of Example 2-1 (thickness: 100 µm) .

### [Examples 2-2 and 2-3]

The procedure of Example 2-1 was repeated, except that the adhesive compositions of Examples 1-2 and 1-3 for use in debonding with light irradiation were respectively used instead of the adhesive composition obtained in Example 1-1 for use in debonding with light irradiation, to thereby form thin films of Examples 2-2 and 2-3.

### [Referential Example 1]

The procedure of Example 2-1 was repeated, except that the composition obtained in Preparation Example 1 was used instead of the adhesive composition obtained in Example 1-1 for use in debonding with light irradiation, to thereby form a thin film of Referential Example 1.

### [Transmittance measurement]

In order to determine whether or not the obtained thin film was usable as a layer for debonding with laser light, light transmittance of the thin film was measured at wavelengths of 308 nm, 355 nm, and 532 nm. Table 1 shows the results.

All the thin films obtained in Examples 2-1 to 2-3 were found to exhibit a decrease in transmittance to laser light at 308 nm, 355 nm, and 532 nm with an increase in the amount of carbon black added, suggesting applicability of the thin films to debonding with laser light radiation. In contrast, the thin film of Referential Example 1 exhibited no absorption of laser light, and the transmittance was 100% in all tested cases.

**[Table 1]**

| | Transmittance (%) | | |
|---|---|---|---|
| | @308 nm | @355 nm | @532 nm |
| Example 2-1 | 80.0 | 80.4 | 81.6 |
| Example 2-2 | 66.0 | 66.6 | 68.1 |
| Example 2-3 | 44.3 | 45.2 | 46.6 |
| Referential Example 1 | 100.0 | 100.0 | 100.0 |

### [3] Determination of optimal irradiation dose of laser light (308 nm) for debonding and detection of heat generation during irradiation

### [Examples 3-1 to 3-3]

The adhesive composition for use in debonding with light irradiation obtained in Example 1-1 was applied, by means of a spin coater, onto a 300-mm silicon wafer (thickness: 700 µm) serving as a device-side wafer (semiconductor component-forming substrate) and heated on a hot plate at 120°C for 1.5 minutes, to thereby form a thin film (an adhesive coating layer).

A 100-mm glass wafer (EAGLE-XG, product of Corning Inc., thickness: 700 µm) serving as a carrier-side wafer (support substrate) was bonded to the silicon wafer so as to sandwich the above-formed thin film between these wafers in a vacuum bonding apparatus. The resultant product was placed on a hot plate so that the device-side wafer was located downward, and heated at 200°C for 10 minutes, to thereby cure the above-formed thin film and to produce a laminate. Bonding was performed at 25°C, and a reduced pressure of 1,000 Pa with a load of 30 N.

Also, the above procedure was repeated, except that the adhesive composition for use in debonding with light irradiation obtained in Example 1-1 was changed to the adhesive compositions of Examples 1-2 and 1-3 for use in debonding with light irradiation, to thereby form laminates.

Each of the resultant three laminates was irradiated with laser light (wavelength: 308 nm) from the glass wafer side by means of a laser irradiation apparatus. In this case, the output was varied, and the minimum irradiation dose required for occurrence of debonding was determined within an output range of 100 to 550 mJ/cm².

As a result, debonding was confirmed at 525 mJ/cm² in each laminate. This value was defined as an optimal irradiation dose, and a debonding test was performed by use of laser light having a wavelength of 308 nm.

Separately, in order to confirm heat generation during laser light irradiation, the temperature of each laminate was measured by means of an infrared radiation thermometer before and after laser light irradiation.

As a result, the temperature of each laminate was found to be about 23°C before laser light irradiation and about 23°C after laser light irradiation. Thus, it was confirmed that substantially no heat generation occurred in the film through laser light irradiation.

### [4] Debonding test by laser light (wavelength: 308 nm)

### [Examples 4-1 to 4-3]

Three additional laminates were produced in the same manner as employed in Examples 3-1 to 3-3. Each of the laminate was irradiated with laser light (wavelength: 308 nm) from the glass wafer side by means of a laser irradiation apparatus so that irradiation was performed over the entire surface of the wafer, and whether or not the glass wafer was removable was checked. In this case, laser irradiation was performed so as to prevent overlapping in front-back and left-right directions. The laser output was adjusted to 525 mJ/cm² in each Example.

As a result, the glass wafer (on the carrier side) was found to be readily removed in each of the laminates of Examples 4-1 to 4-3.

### [5] Determination of optimal irradiation dose of laser light (532 nm) for debonding and detection of heat generation during irradiation

### [Examples 5-1 to 5-3]

Laminates of Examples 5-1 to 5-3 were produced in the same manner as employed in Examples 3-1 to 3-3, respectively.

Each of the three laminates was irradiated with laser light (wavelength: 532 nm) from the glass wafer side by means of a laser irradiation apparatus. In this case, the output was varied, and the minimum irradiation dose required for occurrence of debonding was determined within an output range of 100 to 500 mJ/cm².

As a result, debonding was confirmed at 400 mJ/cm² in each laminate. This value was defined as an optimal irradiation dose, and a debonding test was performed by use of laser light having a wavelength of 532 nm.

Separately, in order to confirm heat generation during laser light irradiation, the temperature of the laminates of Examples 5-1 to 5-3 was measured by means of an infrared radiation thermometer before and after laser light irradiation

As a result, the temperature of each laminate was found to be about 23°C before laser light irradiation and about 24°C after laser light irradiation. Thus, it was confirmed that substantially no heat generation occurred in the film through laser light irradiation.

### [6] Debonding test by laser light (wavelength: 532 nm)

### [Examples 6-1 to 6-3]

Three additional laminates were produced in the same manner as employed in Examples 5-1 to 5-3. Each of the laminate was irradiated with laser light (wavelength: 532 nm) from the glass wafer side by means of a laser irradiation apparatus so that irradiation was performed over the entire surface of the wafer, and whether or not the glass wafer was removable was checked. In this case, laser irradiation was performed so as to prevent overlapping in front-back and left-right directions. The laser output was adjusted to 400 mJ/cm² in all the cases of Examples 6-1 to 6-3.

As a result, the glass wafer (on the carrier side) was found to be readily removed in each of the laminates.

### [Comparative Example 6-1]

The composition obtained in Comparative Example 1-1 (2 g) was dribbled onto a 100-mm silicon wafer (thickness: 500 µm) serving as the device-side wafer (i.e., a semiconductor forming substrate) and spread by means of a spatula, to thereby form a coating film. A 100-mm glass wafer (EAGLE-XG, product of Corning Inc., thickness: 700 µm) serving as a carrier-side wafer (support substrate) was manually bonded to the silicon wafer so as to sandwich the above-formed coating film between these wafers. The resultant product was allowed to stand overnight to cure the coating film, to thereby produce a laminate.

The thus-produced laminate was irradiated with laser light (wavelength: 532 nm) from the glass wafer side by means of a laser irradiation apparatus so that irradiation was performed over the entire surface of the wafer, and whether or not the glass wafer was removable was checked. In this case, laser irradiation was performed so as to prevent overlapping in front-back and left-right directions. The laser output was adjusted to 500 mJ/cm².

As a result, the glass wafer (on the carrier side) was found to be not removed.

### [Examples 8-1 to 8-4]

Laminates were produced in the same manner as employed in Example 3-1, except that the adhesive composition for use in debonding with light irradiation obtained in Example 1-1 was changed to the adhesive compositions of Examples 1-4 to 1-7 for use in debonding with light irradiation.

Each of the four laminates of Examples 8-1 to 8-4 was irradiated with laser light (wavelength: 532 nm) from the glass wafer side by means of a laser irradiation apparatus so that irradiation was performed over the entire surface of the wafer, and whether or not the glass wafer was removable was checked. In this case, laser irradiation was performed so as to prevent overlapping in front-back and left-right directions. The laser output was adjusted to 400 mJ/cm² in each Example.

As a result, the glass wafer (on the carrier side) was found to be readily removed in each of the laminates of Examples 8-1 to 8-4.

### [7] Debonding test by laser light (wavelength: 355 nm)

### [Examples 7-1 to 7-3, Comparative Example 7-1]

Three laminates were produced in the same manner as employed in Examples 5-1 to 5-3, and a laminate was produced in the same manner as employed in Comparative Example 6-1. Each laminate was irradiated with laser light (wavelength: 355 nm) from the glass wafer side by means of a laser irradiation apparatus so that irradiation was performed over the entire surface of the wafer, and whether or not the glass wafer was removable was checked. In this case, laser irradiation was performed so as to prevent overlapping in front-back and left-right directions. The laser output was adjusted to 160 mJ/cm².

As a result, the glass wafer (on the carrier side) was found to be readily removed in each laminate.

In contrast, the glass wafer (on the carrier side) was found to be not removed in the laminate of Comparative Example 6-1.

### [Examples 9-1 to 9-3]

Laminates were produced in the same manner as employed in Example 3-1, except that the adhesive composition for use in debonding with light irradiation obtained in Example 1-1 was changed to the adhesive compositions of Examples 1-4 to 1-6 for use in debonding with light irradiation.

Each of the three laminates of Examples 9-1 to 9-3 was irradiated with laser light (wavelength: 355 nm) from the glass wafer side by means of a laser irradiation apparatus so that irradiation was performed over the entire surface of the wafer, and whether or not the glass wafer was removable was checked. In this case, laser irradiation was performed so as to prevent overlapping in front-back and left-right directions. The laser output was adjusted to 160 mJ/cm² in each Example.

As a result, the glass wafer (on the carrier side) was found to be readily removed in each of the laminates of Examples 9-1 to 9-3.

### Description of Reference Numerals

- 10, 10A: laminate
- 11: first substrate
- 12: second substrate
- 13: adhesive coating layer
- 13A: adhesive layer
- 20: laser light

## Claims

1. An adhesive composition for use in debonding with light irradiation,
which composition can achieve debonding through irradiation with light, **characterized in that**
the adhesive composition comprises an adhesive component and carbon black, and the adhesive component contains a component (A) which is cured through hydrosilylation.

2. An adhesive composition for use in debonding with light irradiation according to claim 1, which further comprises a component (B) containing at least one species selected from the group consisting of a component containing an epoxy-modified polyorganosiloxane, a component containing a methyl-group-containing polyorganosiloxane, and a component a phenyl-group-containing polyorganosiloxane.

3. An adhesive composition for use in debonding with light irradiation according to claim 1 or 2, wherein
the component (A) which is cured through hydrosilylation comprises a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T) (wherein each of R¹ to R⁶ is a group or an atom bonded to a silicon atom and represents an alkyl group, an alkenyl group, or a hydrogen atom) and a platinum group metal catalyst (A2); and
the polysiloxane (A1) comprises a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T' (wherein each of R^{1'} to R^{6'} is a group bonded to a silicon atom and represents an alkyl group or an alkenyl group, and at least one of R^{1'} to R^{6'} is an alkenyl group), and a polyorganosiloxane (a2) having one or more units selected from the group consisting of a siloxane unit represented by SiO₂ (unit Q"), a siloxane unit represented by R^{1"}R^{2"}R^{3"}SiO_{1/2} (unit M"), a siloxane unit represented by R^{4"}R^{5"}SiO_{2/2} (unit D"), and a siloxane unit represented by R^{6"}SiO_{3/2} (unit T"), and at least one unit selected from the group consisting of unit M", unit D", and unit T" (wherein each of R^{1"} to R^{6"} is a group or an atom bonded to a silicon atom and represents an alkyl group or a hydrogen atom, and at least one of R^{1"} to R^{6"} is a hydrogen atom).

4. An adhesive composition for use in debonding with light irradiation according to any one of claims 1 to 3, which has a carbon black content of 0.1 to 50 mass% with respect to the amount of the adhesive component.

5. An adhesive composition for use in debonding with light irradiation according to any one of claims 1 to 4, which contains a solvent.

6. An adhesive composition for use in debonding with light irradiation according to claim 5, which has a solvent content of 10 to 90 mass% with respect to the entire amount of the adhesive composition.

7. An adhesive composition for use in debonding with light irradiation according to any one of claims 1 to 6, which contains a component containing at least one species selected from the group consisting of a component containing an epoxy-modified polyorganosiloxane, a component containing a methyl-group-containing polyorganosiloxane, and a component a phenyl-group-containing polyorganosiloxane.

8. A laminate comprising a first substrate formed of a semiconductor-forming substrate, a second substrate formed of a support substrate which allows passage of laser light, and an adhesive layer, wherein
the adhesive layer is a cured film formed from an adhesive composition for use in debonding with light irradiation as recited in any one of claims 1 to 7.

9. A method for producing a laminate, the method comprising
a first step of applying an adhesive composition for use in debonding with light irradiation as recited in any one of claims 1 to 7 onto a surface of a first or second substrate, to thereby form an adhesive coating layer; and
a second step including adhering the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment.

10. A debonding method comprising irradiating a laminate produced through a laminate production method as recited in claim 9 with laser light from the second substrate side of the laminate, to thereby debond the second substrate.

11. A debonding method according to claim 10, wherein the laser light has a wavelength of 190 nm to 600 nm.

## Patentansprüche

1. Klebstoffzusammensetzung zur Verwendung beim Ablösen durch Lichtbestrahlung,
wobei die Zusammensetzung durch Bestrahlen mit Licht ein Ablösen bewirken kann, **dadurch gekennzeichnet, dass**
die Klebstoffzusammensetzung eine Klebstoffkomponente und Ruß umfasst und die Klebstoffkomponente eine Komponente (A) enthält, die durch Hydrosilylierung gehärtet wird.

2. Klebstoffzusammensetzung zur Verwendung beim Ablösen durch Lichtbestrahlung gemäß Anspruch 1, ferner umfassend eine Komponente (B), die mindestens eine Spezies enthält, die aus der Gruppe ausgewählt ist, die aus einer Komponente, die ein epoxidmodifiziertes Polyorganosiloxan enthält, einer Komponente, die ein methylgruppenhaltiges Polyorganosiloxan enthält, und einer Komponente, die ein phenylgruppenhaltiges Polyorganosiloxan enthält, besteht.

3. Klebstoffzusammensetzung zur Verwendung beim Ablösen durch Lichtbestrahlung gemäß Anspruch 1 oder 2, wobei
die Komponente (A), die durch Hydrosilylierung gehärtet wird, ein Polysiloxan (A1) mit einer oder mehreren Einheiten, die aus der Gruppe ausgewählt sind, die aus einer Siloxaneinheit, dargestellt durch SiO₂ (Q-Einheit), einer Siloxaneinheit, dargestellt durch R¹R²R³SiO_{1/2} (M-Einheit), einer Siloxaneinheit, dargestellt durch R⁴R⁵SiO_{2/2} (D-Einheit), und einer Siloxaneinheit, dargestellt durch R⁶SiO_{3/2} (T-Einheit), besteht (wobei jedes von R¹ bis R⁶ eine Gruppe oder ein Atom, gebunden an ein Siliciumatom, ist und eine Alkylgruppe, eine Alkenylgruppe oder ein Wasserstoffatom darstellt), und einen Platingruppenmetall-Katalysator (A2) umfasst; und
das Polysiloxan (A1) ein Polyorganosiloxan (a1), das eine oder mehrere Einheiten, die aus der Gruppe ausgewählt sind, die aus einer Siloxaneinheit, dargestellt durch SiO₂ (Q'-Einheit), einer Siloxaneinheit, dargestellt durch R^{1'}R^{2'}R^{3'}SiO_{1/2} (M'-Einheit), einer Siloxaneinheit, dargestellt durch R^{4'}R^{5'}SiO_{2/2} (D'-Einheit), und einer Siloxaneinheit, dargestellt durch R^{6'}SiO_{3/2} (T'-Einheit) besteht, und mindestens eine Einheit, ausgewählt aus der Gruppe, bestehend aus M'-Einheit, D'-Einheit und T'-Einheit (wobei jedes von R^{1'} bis R^{6'} eine an ein Siliciumatom gebundene Gruppe ist und eine Alkylgruppe oder eine Alkenylgruppe darstellt und mindestens eines von R^{1'} bis R^{6'} eine Alkenylgruppe ist) aufweist, und ein Polyorganosiloxan (a2), das eine oder mehrere Einheiten, die aus der Gruppe ausgewählt sind, die aus einer Siloxaneinheit, dargestellt durch SiO₂ (Q"-Einheit), einer Siloxaneinheit, dargestellt durch R^{1"}R^{2"}R^{3"}SiO_{1/2} (M"-Einheit), einer Siloxaneinheit, dargestellt durch R^{4"}R^{5"}SiO_{2/2} (D"-Einheit), und einer Siloxaneinheit, dargestellt durch R^{6"}SiO_{3/2} (T''-Einheit) besteht, und mindestens eine Einheit, ausgewählt aus der Gruppe bestehend aus M"-Einheit, D"-Einheit und T"-Einheit (wobei jedes von R^{1"} bis R^{6"} eine Gruppe oder ein Atom, gebunden an ein Siliciumatom, ist und eine Alkylgruppe oder ein Wasserstoffatom darstellt, und mindestens eines von R^{1"} bis R^{6"} ein Wasserstoffatom ist), umfasst.

4. Klebstoffzusammensetzung zur Verwendung beim Ablösen durch Lichtbestrahlung gemäß einem der Ansprüche 1 bis 3, die einen Rußgehalt von 0,1 bis 50 Massen-%, bezogen auf die Menge der Klebstoffkomponente, aufweist.

5. Klebstoffzusammensetzung zur Verwendung beim Ablösen durch Lichtbestrahlung gemäß einem der Ansprüche 1 bis 4, enthaltend ein Lösungsmittel.

6. Klebstoffzusammensetzung zur Verwendung beim Ablösen durch Lichtbestrahlung gemäß Anspruch 5, die einen Lösungsmittelgehalt von 10 bis 90 Massen-%, bezogen auf die Gesamtmenge der Klebstoffzusammensetzung, aufweist.

7. Klebstoffzusammensetzung zur Verwendung beim Ablösen durch Lichtbestrahlung gemäß einem der Ansprüche 1 bis 6, enthaltend eine Komponente, die mindestens eine Spezies enthält, die aus der Gruppe ausgewählt ist, die aus einer Komponente, die ein epoxidmodifiziertes Polyorganosiloxan enthält, einer Komponente, die ein methylgruppenhaltiges Polyorganosiloxan enthält, und einer Komponente, die ein phenylgruppenhaltiges Polyorganosiloxan enthält, besteht.

8. Laminat, umfassend ein erstes Substrat, gebildet aus einem halbleiterbildenden Substrat, ein zweites Substrat, gebildet aus einem Trägersubstrat, das den Durchgang von Laserlicht ermöglicht, und eine Klebeschicht, wobei
die Klebeschicht ein gehärteter Film ist, der aus einer Klebstoffzusammensetzung zur Verwendung beim Ablösen durch Lichtbestrahlung, wie in einem der Ansprüche 1 bis 7 beschrieben, gebildet ist.

9. Verfahren zur Herstellung eines Laminats, wobei das Verfahren umfasst
einen ersten Schritt des Aufbringens einer Klebstoffzusammensetzung zur Verwendung beim Ablösen durch Lichtbestrahlung, wie in einem der Ansprüche 1 bis 7 beschrieben, auf eine Oberfläche eines ersten oder zweiten Substrats, um dadurch eine Klebstoffbeschichtungsschicht zu bilden; und
einen zweiten Schritt, umfassend das Anhaften des ersten Substrats an das zweite Substrat unter Vermittlung der Klebstoffbeschichtungsschicht; das Anwenden einer Last auf das erste Substrat und das zweite Substrat in einer Dickenrichtung, um dadurch das erste Substrat, die Klebstoffbeschichtungsschicht und das zweite Substrat fest miteinander zu binden, während mindestens eines von einer Wärmebehandlung und einer Unterdruckbehandlung durchgeführt wird; und das anschließende Durchführen einer Nachwärmebehandlung.

10. Verfahren zum Ablösen, umfassend das Bestrahlen eines durch ein Laminatherstellungsverfahren, wie in Anspruch 9 beschrieben, hergestellten Laminats mit Laserlicht von der zweiten Substratseite des Laminats, um dadurch das zweite Substrat abzulösen.

11. Verfahren zum Ablösen gemäß Anspruch 10, wobei das Laserlicht eine Wellenlänge von 190 nm bis 600 nm aufweist.

## Revendications

1. Composition adhésive destinée à être utilisée dans le pelage par irradiation optique,
laquelle composition peut effectuer un pelage par irradiation optique, **caractérisée en ce que**
la composition adhésive comprend un composant adhésif et du noir de carbone, et le composant adhésif contient un composant (A) qui est durci par hydrosilylation.

2. Composition adhésive destinée à être utilisée dans le pelage par irradiation optique selon la revendication 1, qui comprend en outre un composant (B) contenant au moins une espèce choisie dans le groupe consistant en un composant contenant un polyorganosiloxane modifié par époxy, un composant contenant un polyorganosiloxane contenant un groupe méthyle, et un composant contenant un polyorganosiloxane contenant un groupe phényle.

3. Composition adhésive destinée à être utilisée dans le pelage par irradiation optique selon la revendication 1 ou 2, dans laquelle
le composant (A) qui est durci par hydrosilylation comprend un polysiloxane (A1) présentant une ou plusieurs unités choisies dans le groupe consistant en une unité siloxane représentée par SiO₂ (unité Q), une unité siloxane représentée par R¹R²R³SiO_{1/2} (unité M), une unité siloxane représentée par R⁴R^{S}SiO_{2/2} (unité D),
et une unité siloxane représentée par R⁶SiO_{3/2} (unité T) (dans laquelle chacun de R¹ à R⁶ est un groupe ou un atome lié à un atome de silicium et représente un groupe alkyle, un groupe alcényle ou un atome d'hydrogène) et un catalyseur à base d'un métal du groupe du platine (A2) ; et
le polysiloxane (A1) comprend un polyorganosiloxane (a1) présentant une ou plusieurs unités choisies dans le groupe consistant en une unité siloxane représentée par SiO₂ (unité Q'), une unité siloxane représentée par R^{1'}R^{2'}R^{3'}SiO_{1/2} (unité M'), une unité siloxane représentée par R⁴' R⁵' SiO_{2/2} (unité D'), et une unité siloxane représentée par R⁶'SiO_{3/2} (unité T'), et au moins une unité choisie dans le groupe consistant en l'unité M', l'unité D',
et l'unité T' (dans laquelle chacun de R¹' à R⁶' est un groupe lié à un atome de silicium et représente un groupe alkyle ou un groupe alcényle, et au moins un de R¹' à R⁶' est un groupe alcényle),
et un polyorganosiloxane (a2) présentant une ou plusieurs unités choisies dans le groupe consistant en une unité siloxane représentée par SiO₂ (unité Q"), une unité siloxane représentée par R¹"R²"R³"SiO_{1/2} (unité M"), une unité siloxane représentée par R⁴"R⁵"SiO_{2/2} (unité D"),
et une unité siloxane représentée par R⁶"SiO_{3/2} (unité T"), et au moins une unité choisie dans le groupe consistant en l'unité M", l'unité D", et l'unité T" (dans laquelle chacun de R¹" à R⁶" est un groupe ou un atome lié à un atome de silicium et représente un groupe alkyle ou un atome d'hydrogène, et au moins un de R¹" à R⁶" est un atome d'hydrogène).

4. Composition adhésive destinée à être utilisée dans le pelage par irradiation optique selon l'une quelconque des revendications 1 à 3, qui présente une teneur en noir de carbone de 0,1 % à 50 % en masse par rapport à la quantité du composant adhésif.

5. Composition adhésive destinée à être utilisée dans le pelage par irradiation optique selon l'une quelconque des revendications 1 à 4, qui contient un solvant.

6. Composition adhésive destinée à être utilisée dans le pelage par irradiation optique selon la revendication 5, qui présente une teneur en solvant de 10 % à 90 % en masse par rapport à la quantité totale de la composition adhésive.

7. Composition adhésive destinée à être utilisée dans le pelage par irradiation optique selon l'une quelconque des revendications 1 à 6, qui contient un composant contenant au moins une espèce choisie dans le groupe consistant en un composant contenant un polyorganosiloxane modifié par époxy, un composant contenant un polyorganosiloxane contenant un groupe méthyle, et un composant contenant un polyorganosiloxane contenant un groupe phényle.

8. Corps stratifié comprenant un premier substrat formé d'un substrat de formation de semi-conducteur, un second substrat formé d'un substrat support qui permet le passage de la lumière laser, et une couche adhésive, dans lequel
la couche adhésive est un film durci formé à partir d'une composition adhésive destinée à être utilisée dans le pelage par irradiation optique selon l'une quelconque des revendications 1 à 7.

9. Procédé de production d'un corps stratifié, le procédé comprenant
une première étape consistant à appliquer une composition adhésive destinée à être utilisée dans le pelage par irradiation optique selon l'une quelconque des revendications 1 à 7 sur une surface d'un premier ou d'un second substrat, pour ainsi former une couche de revêtement adhésive ; et
une seconde étape incluant l'adhérence du premier substrat au second substrat par l'intermédiaire de la couche de revêtement adhésive ; l'application d'une charge au premier substrat et au second substrat dans une direction d'épaisseur, pour ainsi lier étroitement le premier substrat, la couche de revêtement adhésive, et le second substrat, tandis qu'au moins un d'un traitement thermique et d'un traitement sous pression réduite est réalisé ; puis la réalisation d'un post-traitement thermique.

10. Procédé de pelage comprenant l'irradiation d'un corps stratifié produit par un procédé de production de corps stratifié selon la revendication 9 avec de la lumière laser depuis le côté du second substrat du corps stratifié, pour ainsi peler le second substrat.

11. Procédé de pelage selon la revendication 10, dans lequel la lumière laser présente une longueur d'onde de 190 nm à 600 nm.
